# EUROPEAN PATENT SPECIFICATION

(11) **EP 4 280 290 B1**
(45) Date of publication and mention of the grant of the patent: **04.03.2026**
(21) Application number: 21919845.4
(22) Date of filing: 03.11.2021
(51) Int. Cl.: G02B 3/00, G02B 6/00, F21K 9/69, F21K 9/68, H10H 20/853, H10H 20/856

(54) **LIGHT-EMITTING DEVICE PACKAGE HAVING HALF-DOME-SHAPED LENS MEMBER, AND LIGHT-EMITTING DEVICE USING SAME**
GEHÄUSE FÜR LICHTEMITTIERENDE VORRICHTUNG MIT HALBKUPPELFÖRMIGEM LINSENELEMENT UND LICHTEMITTIERENDE VORRICHTUNG DAMIT
BOÎTIER DE DISPOSITIF ÉLECTROLUMINESCENT PRÉSENTANT UN ÉLÉMENT DE LENTILLE EN FORME DE DEMI-DÔME ET DISPOSITIF ÉLECTROLUMINESCENT UTILISANT CE BOÎTIER

(30) Priority: 14.01.2021 KR 20210005421
(43) Date of publication of application: 22.11.2023
(73) Proprietor: Jin, Jea Un, Iksan-si Jeollabuk-do 54658 (KR); Jin, Won Gun, Iksan-si Jeollabuk-do 54658 (KR)
(72) Inventor: Jin, Jea Un, Iksan-si Jeollabuk-do 54658 (KR); Jin, Won Gun, Iksan-si Jeollabuk-do 54658 (KR)
(74) Representative: dompatent
(86) International application number: PCT/KR2021/015761
(87) International publication number: WO 2022/154221

(56) References cited:
- JP-A- 2004 288 866
- KR-A- 20120 039 701
- KR-A- 20120 118 693
- KR-B1- 102 105 793
- KR-B1- 102 305 219
- US-A1- 2002 085 390
- US-A1- 2004 156 209
- US-A1- 2005 173 721
- US-A1- 2011 062 470
- US-A1- 2012 119 230
- US-A1- 2013 070 441

## Description

### Technical Field

The present invention relates to a half-dome-shaped light-emitting device package, and a light-emitting device using the same. More specifically, the present invention relates to a light-emitting device package, and a light-emitting device using the same, wherein a lens member capable of controlling a beam angle by refracting light emitted from a light-emitting device chip has a half dome shape to include a region in which the light-emitting device chip is placed, and while facing the support member, has a recess so that a beam angle control member is inserted into the lens member, so as to control the beam angle of the light emitted from the light-emitting device chip.

By using the light-emitting device package having such a half-dome-shaped lens member, a desired beam angle is controlled and light pollution is reduced through control of unnecessary light radiation. Additionally, energy saving is achieved as luminance is improved.

### Background Art

A generally used light-emitting device package is a light-emitting device package in which a light-emitting device chip, such as a light-emitting diode (LED), is mounted on a substrate or a lead frame and the upper part of the light-emitting device chip is covered by a dome-shaped lens, etc.

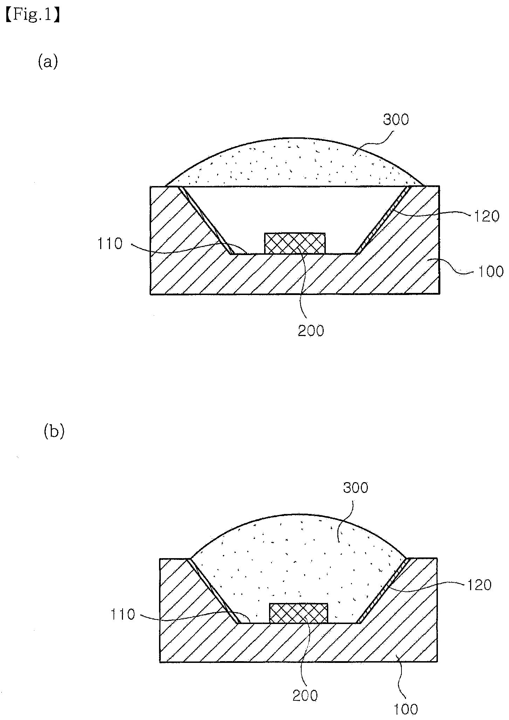

For example, in the related art, a light-emitting device package as shown in FIG. 1 is used, wherein the light-emitting device package includes a lens 300 of which the upper surface is formed to be a convex curved surface with a sag to control a beam angle of light emitted from a light-emitting device chip 200 to widen the beam angle, the lens 300 being combined with the light-emitting device chip 200 to cover the upper part thereof.

In addition, various embodiments are disclosed having a feature of enabling control so that the height of the sag formed on the upper surface of the lens 300 in order to control the beam angle ranges from 10 to 30 % of the diameter of the lens 300 at the point at which the sag starts.

Through this, light can be evenly emitted without bright spots (hot spots) formed in an output screen, and the beam angle can be widened with a simpler shaped lens. Furthermore, by minimizing a mixing area in which light of different colors is mixed, a light-emitting device package capable of realizing a thin product, and a backlight unit using the light-emitting device package are provided.

However, the structure of the light-emitting device package has a purpose that the lens enables the full width at half maximum of a light distribution pattern to have a large beam angle of 120° or more. It is known that if the sag height formed on the of the upper surface of the lens 300 is greater than 0.5 mm, the beam angle is reduced, resulting in a problem that emission efficiency is significantly decreased.

Considering this, a new lens structure for adjusting a beam angle may be required. If an additional lens is required for the new lens structure, there may be problems such as increases in price, package size, and manufacturing complexity due to the introduction of the lens. Accordingly, there is a need for an appropriate structure of a light-emitting device package capable of controlling a beam angle with a simple structure without introducing an additional lens, and capable of reducing the beam angle to a desired value and not reducing luminance significantly.

US 2005/173721 A1 discloses a light-emitting diode package including a light-emitting diode chip mounted on a support member and a lens member having an upper surface in a half dome shape and a recess formed at a lower surface to reflect the light emitted from the light-emitting diode chip.

US 2013/070441 A1 and JP 2004-288866 A disclose a light-emitting diode package including a light-emitting diode chip mounted on a support member, a reflective member to reflect the light emitted from the light-emitting diode chip, and a lens member having an upper surface in a half dome shape placed over the light-emitting diode chip and the reflective member.

KR 102105793 B1 discloses a light-emitting diode package including a light-emitting diode chip mounted on a support member, a first and second reflective member to reflect the light emitted from the light-emitting diode chip, and a lens member having an upper surface in a half dome shape placed over the light-emitting diode chip and the first and second reflective member.

### Disclosure

### Technical Problem

The present invention is based on the aforementioned need, and the present invention aims to enable control of a beam angle to be within a predetermined range by emitting light through a lens member having a beam angle control member in order to control light emitted from a light-emitting device chip.

In addition, the present invention aims to simply control a beam angle of light emitted from the light-emitting device chip into various angles through the structure of the lens member having the beam angle control member, so that manufacturing cost is reduced without introducing an additional lens, reliability is increased, and luminance is increased and energy saving is achieved by emitting the light to a desired region.

### Technical Solution

The present invention provides a beam-angle-adjusted light-emitting device package as defined by claim 1.

In addition, the present invention provides a light-emitting device, such as a display device, as defined by claim 4.

### Advantageous Effects

The light-emitting device package according to the present invention can enable control of the beam angle in a particular direction efficiently by adopting the structure related to the lens member associated with the beam angle control member, thereby reducing light pollution.

Furthermore, the beam-angle-adjusted light-emitting device package and the light-emitting device using the same can be manufacture without additional lenses, thereby reducing manufacturing cost and achieving energy saving with luminance improvement due to suppression of light loss.

### Description of Drawings

FIG. 1 is cross-sectional views of light-emitting device packages in the related art, wherein FIG. 1(a) is a cross-sectional view of a structure in which a lens 300 of which an upper surface is convex is combined to be mounted on an upper surface of a housing 100, and FIG. 1(b) is a cross-sectional view of a structure in which the lens 300 occupies a recess 110 of the housing 100.
FIG. 2 is cross-sectional views of a beam-angle-adjusted light-emitting device package according to an embodiment of the present invention, wherein FIG. 2(a) shows an example of being mounted on a lead frame, and FIG. 2(b) shows an example of being mounted on a printed circuit board.
FIG. 3 is a perspective view of a lens member 240 included in a beam-angle-adjusted light-emitting device package according to an embodiment of the present invention.
FIG. 4 is cross-sectional views of a beam-angle-adjusted light-emitting device package depending on cross-sectional shapes of a beam angle control member according to an embodiment of the present invention, taken along line A-A, wherein FIGS. 4(a) and 4(b) show trapezoidal and rectangular cross-sectional shapes, respectively.
FIGS. 5(a) and 5(b) respectively show results of measuring a beam angle in the related art and a beam-angle-adjusted light-emitting device package according to an embodiment of the present invention.

### Best Mode

Hereinafter, embodiments of the present invention will be described in detail with reference to the accompanying drawings. It should be understood that the embodiments of the present invention may be changed to a variety of embodiments within the scope of the present invention as defined by the claims. The embodiments of the present invention are provided in order to fully explain the invention for those skilled in the art. Therefore, shapes and detailed configurations of elements in the drawings are simplified for description. In addition, it is noted that the terms used in this specification should be interpreted as appropriately describing exemplary embodiments of the present invention.

In addition, in the description with reference to the accompanying drawings, the same reference numerals are given to the same elements throughout the drawings, and a redundant description related thereto will be omitted. In describing the present invention, if it is decided that a detailed description of known technology makes the gist of the present invention unclear, the detailed description will be omitted.

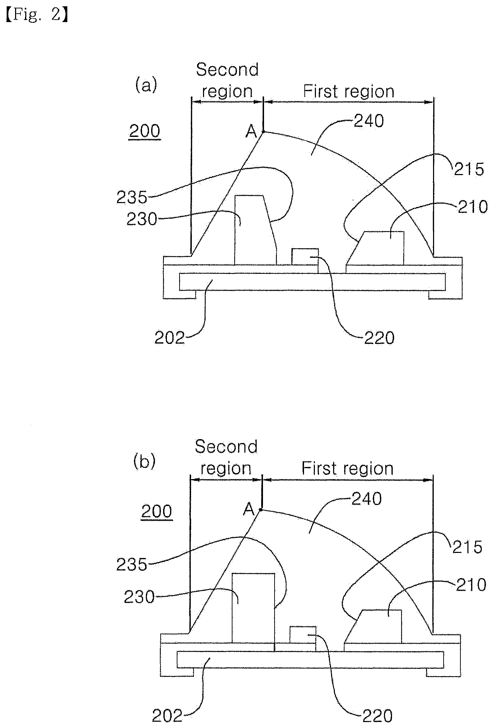

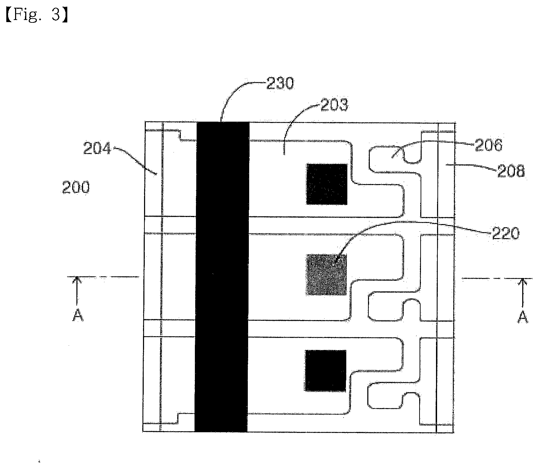

A cross-sectional view of a surface-mounted light-emitting device package with a controlled beam angle and a perspective view of a lens member according to the present invention are shown in FIGS. 2 and 3, respectively. Herein, FIG. 2 shows a cross-section of the light-emitting device package including the lens member shown in FIG. 3 and a light-emitting device chip mounted on an upper surface of a support member, taken along a central reference (line A-A) of the lens member. Specifically, FIG. 2(a) shows an embodiment in which the light-emitting device chip is mounted on a lead frame, and FIG. 2(b) shows an embodiment in which the light-emitting device chip is mounted on a printed circuit board.

As shown in FIG. 2, in a surface-mounted light-emitting device package 200, which is an exemplary embodiment of the present disclosure, with an adjusted beam angle, at least one light-emitting device chip 220 may be mounted on a support member 202 in an internal mounting space of the package. Herein, a plurality of the light-emitting device chips may be mounted spaced apart from each other, for example, red (R), green (G), and blue (B), which are the three primary colors of light. If necessary, one or more light-emitting device chips including a white (W) light-emitting device chip may be mounted. In addition, the support member 202 on which the light-emitting device chip is mounted may be a printed circuit board, a lead frame, or any housing.

There may be various examples depending on the type of the support member. Based an embodiment shown in FIGS. 2(a) and 3, the light-emitting device package includes: a first lead frame 203 on which a light-emitting device chip 220 is mounted corresponding to the number of light-emitting device chips, the first lead frame 203 being supported by the support member 202; a first terminal 204 including at least one first lead terminal that extends from the first lead frame 203 and is exposed to the outside of the package corresponding to the number of light-emitting device chips; at least one second lead frame 206 spaced apart from the first lead frame 203 and exposed to the internal mounting space of the package; and a second terminal 208 including at least one second lead terminal that extends from the second lead frame and is exposed to the outside of the package.

One or more light-emitting device chips 220 may be arranged per light-emitting device package, and the first and second lead frames and the first and second lead terminals may be arranged in pairs corresponding to the number of light-emitting device chips. As described in the previous example, various lead frames and lead terminals may be designed corresponding to the demand for the light-emitting device chips.

In addition, the beam-angle-adjusted light-emitting device package 200 includes: a reflective member 210 that acts to form a beam angle by refracting light emitted from the light-emitting device chip in association with the light-emitting device chip 220 mounted on the support member 202 such as a printed circuit board or a lead frame; a beam angle control member 230; a molding member formed to surround the light-emitting device chip 220, in a space between the reflective member 210 and the beam angle control member 230; and a lens member 240 formed thereover.

Herein, the lens member 240 has a recess (no reference numeral) formed in the inner lower surface of the lens member 240 so that the reflective member 210 and the beam angle control member 230 capable of controlling the beam angle of light emitted from the light-emitting device chip are combined in the recess corresponding to the shape of the combination. Herein, the lower surface of the beam angle control member 230 is placed to face a mounting surface on which the light-emitting device chip 220 is mounted. The beam angle control member 230 is placed such that a second reflective surface 235, which is the side of the beam angle control member 230, is substantially parallel to the nearest side of the light-emitting device chip 220 and is spaced apart therefrom by a separation distance (d) and the upper surface of the light-emitting device chip 220 is not covered by the beam angle control member 230. The lens member 240 may be manufactured using a die casting device having a mold cavity corresponding to the shape of the lens member 240.

The recess formed in the lens member 240 may be shaped corresponding to the shapes of the components of the reflective member 210, the molding member, and the beam angle control member 230, and these components may be fitted into the recess and combined. Furthermore, preferably, at least the reflective member 210, the upper surface of the molding member, and the second reflective surface 235 of the beam angle control member 230 among the components are combined as if substantially integrated, minimizing an exposed surface inside the recess and the separation distance.

The beam angle control member 230 for controlling a beam angle is made of a material different from that of the lens member 240, comprehensively considering reflection characteristics and optimal luminance characteristics. The beam angle control member 230 and the reflective member 210 are selected from, as a high-strength material, a variety of materials that are lightweight, resistant to external impact, have excellent heat resistance, durability, and light transmittance, and are not affected by temperature change or moisture. In accordance with the present invention, polyphthalamide (PPA) or polycyclohexylene terephthalate (PCT) are used. In accordance with the present invention, the lens member 240 is made of silicone.

In addition, a reflective film may be additionally formed on either the first reflective surface 215 of the reflective member 210 or at least the second reflective surface 235 of the beam angle control member 230 or both. As the reflective film, various well-known reflective films (not shown) may be additionally formed, including a single or a plurality of metal coating layers made of one selected from among metals, such as aluminum, aluminum alloy, zirconium alloy, etc., and multilayer reflective layers made of dielectrics, considering reflection characteristics, luminance improvement, and the wavelength of emitted light.

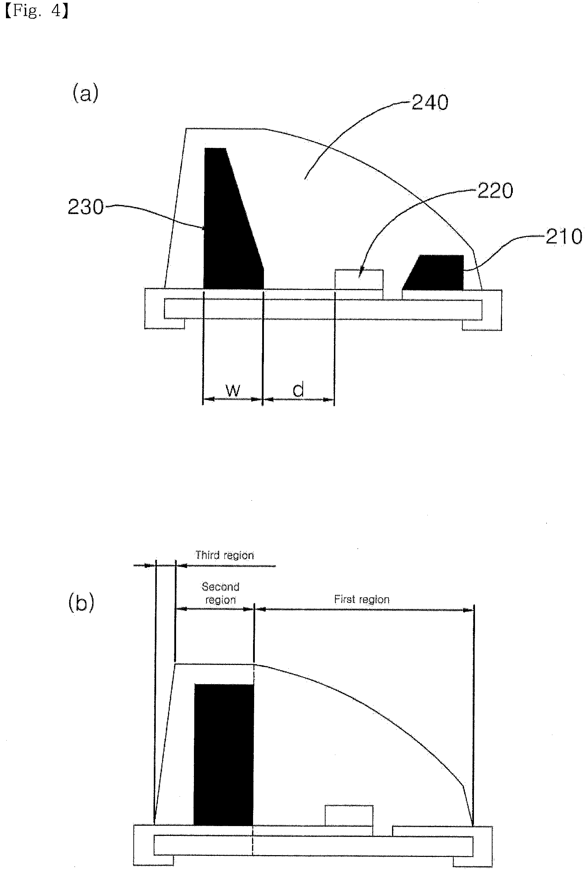

To effectively control a beam angle, the cross-sectional shape of the beam angle control member 230 may be a trapezoidal shape, as shown in FIG. 4(a), with an incline that is the side toward the light-emitting device chip, or a rectangular shape, as shown in FIG. 4(b). The incline of the trapezoidal shape may be a straight surface in the cross-sectional shape as shown in FIG. 4(a). However, due to need for control of the beam angle, the incline of the beam angle control member 230 may be a reflective surface that is bent inward, rather than a straight surface. In addition to the various shapes described above, the cross-sectional shape of the beam angle control member 230 may be changed into various shapes in terms of design according to arrangements of the support member and the light-emitting device chip, without departing from the scope of beam angle control characteristics of the present invention.

In the meantime, the width (w) of the beam angle control member 230 is not particularly limited, but is as narrow as possible (for example, 0.30 mm), preferably. The height (h) of the beam angle control member 230 may be affected by the separation distance (d) between the light-emitting device chip 220 and the beam angle control member 230, and needs to be greater than the thickness of the light-emitting device chip 220. Preferably, the height (h) of the beam angle control member 230 may be at least twice the thickness of the light-emitting device chip 220, and more preferably, may range from 3 to 10 times. As an example, when the separation distance (d) is 0.36 mm and the thickness of the light-emitting device chip 220 is 0.1 mm, the height of the beam angle control member 230 may have a value around 0.7 mm.

The shape of the outermost surface of the lens member 240 including the beam angle control member 230 is described according to a first region and a second region separately, as shown in FIGS. 2 and 3. Specifically, the lens member 240 may include: the first region including a region in which the reflective member 210 and the light-emitting device chip 220 are placed at the position of the line A-A of FIG. 3, and having an upper surface in a half dome shape; and the second region including a region in which the beam angle control member 230 is placed, and having from the uppermost position (A) to the upper surface of the support member 202, a cross section in a triangular shape with a straight line.

Herein, a line formed by extending the second reflective surface 235, among the surfaces of the beam angle control member 230, reflecting light emitted from the light-emitting device chip toward the upper surface of the support member 202 is formed to coincide with a line formed by extending a boundary between the first region and the second region toward the upper surface of the support member. In another example, in order to control a beam angle range, not forming part of the present invention, a line formed by extending from the uppermost position (A) toward the upper surface of the support member 202 may be formed to substantially coincide with a line formed by extending the side of the light-emitting device chip 220 near the beam angle control member 230, toward the upper surface of the support member 202. In the meantime, the second reflective surface 235 of the beam angle control member 230 is placed to be substantially parallel to the nearest side of the light-emitting device chip 220 and is spaced apart therefrom. The expressions 'substantially coincide' and 'substantially parallel' may be understood to include the meaning of being in an error range commonly predictable when manufactured.

It should be understood that the relative arrangement between components, such as the uppermost position (A) at the lens member 240, the material and height of the beam angle control member 230, the shape of the second reflective surface 235, the light-emitting device chip 220 and the beam angle control member 230, the separation distance to the second reflective surface, etc., may be changed into various forms in terms of design according to the optimal or desired beam angle characteristics. Through a process of optimizing the arrangement of the components and control of the curvature of the half dome of the lens member 240, the beam angle of the light-emitting device package is controlled, thereby minimizing light emitted to an unnecessary region. Luminance improvement and energy saving are achieved by concentrating light emitted within the beam angle.

In the meantime, as shown in FIG. 2(b), the light-emitting device package in which the light-emitting device chip 220 is mounted on the printed circuit board has the support member 202 of which the form is simply switched from the lead frame to the printed circuit board, compared to FIG. 2(a) previously described. All other features except for this can be applied in the same manner as described above with reference to FIG. 2(a).

As shown in FIGS. 4(a) and 4(b), the upper surface of the lens member 240 may be formed differently depending on a third region corresponding to the upper surface of the beam angle control member 230 between the first region and the second region described above. The first region represents a region in which the light-emitting device chip 220 is formed and the region is located on the right side of the figure with respect to the beam angle control member 230. The second region represents a region opposite to the first region with respect to the third region in which the beam angle control member 230 is placed. Herein, the shape of the outermost surface of the lens member 240 may have a straight surface in the third region that is substantially the same as the mounting surface of the light-emitting device chip 220. Preferably, in the first region, a convex surface shape like a half-dome shape is formed. In the second region, a curved surface or a substantially straight surface is formed toward the mounting surface. Of course, for manufacturing convenience, the shape of the outermost surface of the lens member 240 in the second region and the third region may be formed to have a curved surface or a substantially straight surface toward the mounting surface, as shown in FIG. 2.

The connection between the lens member 240 and the support member 202 may be achieved by using an adhesive, or the lens member 240 and the support member 202 may be combined by using an additional combination member (not shown) considering precision.

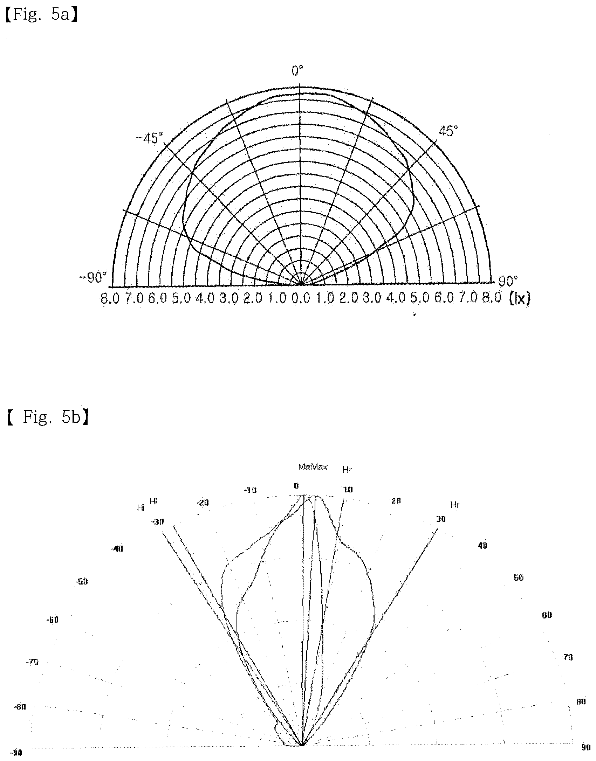

FIGS. 5b and 5a respectively show results of measuring a beam angle in a vertical direction for a beam-angle-adjusted light-emitting device package according to an embodiment of the present disclosure and a surface-mounted light-emitting device package in the related art as shown in FIG. 1. As can be seen from the comparison in the figures, it is found that a beam angle in the related art (FIG. 5a) is about 140°, while a beam angle in the embodiment (FIG. 5b) is about 60°, which is reduced to a significant degree.

The beam-angle-adjusted light-emitting device package 200 described above may be applied to a light-emitting device, such as various display devices including as outdoor billboards, road signs, etc. A plurality of light-emitting device packages according to an embodiment of the present disclosure are combined and configured as modules, and the modules are arranged on a plane to configure a light-emitting device, such as display devices including billboards, etc.

In this light-emitting device, preferably, a beam angle for each of the plurality of modules or each of the light-emitting device packages within the modules is individually controlled, thereby minimizing light pollution in regions where display is not needed.

The present invention has been described with reference to the embodiments shown in the drawings for illustrative purposes, and those skilled in the art will understand that various modifications can be made. It will be apparent that the scope of the present invention is defined by the claims set forth below.

## Claims

1. A beam-angle-adjusted light-emitting device package, comprising:
a light-emitting device chip (220) mounted on an upper surface of a support member (202);
a reflective member (210) at which a first reflective surface (215) reflecting the light emitted from the light-emitting device chip (220) is formed;
a beam angle control member (230) at which a second reflective surface (235) reflecting the light emitted from the light-emitting device chip (220) is formed; and
a lens member (240) refracting the light emitted from the light-emitting device chip (220) to form a beam angle,
wherein the lens member (240) is made of silicone,
wherein the lens member (240) includes a first region and a second region, the first region having an upper surface in a sectioned half dome shape,
wherein the light-emitting device chip (220) and the reflective member (210) are placed in the first region and the beam angle control member (230) is placed in the second region,
wherein, while facing the support member (²⁰²)^{,} the lens member (240) has a recess so that the reflective member (210) and the dd beam angle control member (230) are inserted into the lens member (240), so as to control the beam angle of the light emitted from the light-emitting device chip (220), wherein the reflective member (210) and the beam angle control member (230) are made of polyphthalamide (PPA) or polycyclohexylene terephthalate (PCT),
wherein a cross-sectional shape of the second region excluding the first region has a straight surface with an angle,
wherein a line formed by extending the second reflective surface (235) toward the upper surface of the support member (202) is formed to coincide with a line formed by extending a boundary between the first region and the second region toward the upper surface of the support member (202), and
wherein a cross-sectional shape of the beam angle control member (230) is a rectangular shape.

2. The light-emitting device package of claim 1, wherein the second reflective surface (235) of the beam angle control member (230) is placed to be parallel to a nearest side of the light-emitting device chip (220) and is spaced apart therefrom.

3. The light-emitting device package of claim 2, wherein the light-emitting device chip (220) is one or a plurality of the light-emitting device chips (220) that are placed spaced apart from each other.

4. A light-emitting device comprising a beam-angle-adjusted light-emitting device package according to any one of claims 1, 2, and 3, wherein a beam angle of the emitted light is adjusted using the light-emitting device package.

## Patentansprüche

1. Gehäuse für eine lichtemittierende Vorrichtung mit eingestelltem Abstrahlwinkel, aufweisend:
einen Chip (220) einer lichtemittierenden Vorrichtung, der auf einer oberen Fläche eines Trägerelements (202) angebracht ist;
ein reflektierendes Element (210), an dem eine erste reflektierende Fläche (215) ausgebildet ist, die das von dem Chip (220) der lichtemittierenden Vorrichtung emittierte Licht reflektiert;
ein Abstrahlwinkelsteuerelement (230), an dem eine zweite reflektierende Fläche (235), die das von dem Chip (220) der lichtemittierenden Vorrichtung emittierte Licht reflektiert, ausgebildet ist; und
ein Linsenelement (240), welches das von dem Chip (220) der lichtemittierenden Vorrichtung emittierte Licht bricht, um einen Abstrahlwinkel zu bilden, wobei das Linsenelement (240) aus Silizium besteht,
wobei das Linsenelement (240) einen ersten Bereich und einen zweiten Bereich umfasst, wobei der erste Bereich eine obere Fläche in einer geteilten Halbkuppelform aufweist, wobei der Chip (220) der lichtemittierende Vorrichtung und das reflektierende Element (210) in dem ersten Bereich platziert sind und das Abstrahlwinkelsteuerelement (230) in dem zweiten Bereich platziert ist,
wobei das Linsenelement (240), während es dem Trägerelement (202) zugewandt ist, eine Aussparung aufweist, so dass das reflektierende Element (210) und das Abstrahlwinkelsteuerelement (230) in das Linsenelement (240) eingesetzt sind, um den Abstrahlwinkel des von dem Chip (220) der lichtemittierenden Vorrichtung emittierten Lichts zu steuern, wobei das reflektierende Element (210) und das Abstrahlwinkelsteuerelement (230) aus Polyphthalamid (PPA) oder Polycyclohexylenterephthalat (PCT) bestehen,
wobei eine Querschnittsform des zweiten Bereichs, der den ersten Bereich ausschließt, eine gerade Fläche mit einem Winkel aufweist,
wobei eine Linie, die durch Erstrecken der zweiten reflektierenden Fläche (235) in Richtung der oberen Fläche des Trägerelements (202) gebildet wird, so ausgebildet ist, dass sie mit einer Linie zusammenfällt, die durch Erstrecken einer Grenze zwischen dem ersten Bereich und dem zweiten Bereich in Richtung der oberen Fläche des Trägerelements (202) gebildet wird, und wobei eine Querschnittsform des Abstrahlwinkelsteuerelements (230) eine rechteckige Form ist.

2. Gehäuse für eine lichtemittierende Vorrichtung nach Anspruch 1, wobei die zweite reflektierende Fläche (235) des Abstrahlwinkelsteuerelements (230) so platziert ist, dass sie parallel zu einer nächstgelegenen Seite des Chips (220) der lichtemittierenden Vorrichtung verläuft und von dieser beabstandet ist.

3. Gehäuse für eine lichtemittierende Vorrichtung nach Anspruch 2, wobei der Chip (220) der lichtemittierenden Vorrichtung einer oder eine Vielzahl der Chips (220) der lichtemittierenden Vorrichtung ist, die voneinander beabstandet angeordnet sind.

4. Lichtemittierende Vorrichtung mit einem Gehäuse für eine lichtemittierende Vorrichtung mit eingestelltem Abstrahlwinkelnach einem der Ansprüche 1, 2 und 3, wobei ein Abstrahlwinkel des emittierten Lichts unter Verwendung des Gehäuses für die lichtemittierende Vorrichtung eingestellt wird.

## Revendications

1. Boîtier de dispositif électroluminescent à angle de faisceau réglé, comprenant :
une puce de dispositif électroluminescent (220) montée sur une surface supérieure d'un élément support (202) ;
un élément réfléchissant (210) au niveau duquel est formée une première surface réfléchissante (215) réfléchissant la lumière émise à partir de la puce de dispositif électroluminescent (220) ;
un élément de commande d'angle de faisceau (230) au niveau duquel est formée une seconde surface réfléchissante (235) réfléchissant la lumière émise à partir de la puce de dispositif électroluminescent (220) ; et
un élément lentille (240) réfractant la lumière émise à partir de la puce de dispositif électroluminescent (220) pour former un angle de faisceau, dans lequel l'élément lentille (240) est en silicone,
dans lequel l'élément lentille (240) comprend une première région et une seconde région, la première région comportant une surface supérieure en une forme de demi-dôme coupé,
dans lequel la puce de dispositif électroluminescent (220) et l'élément réfléchissant (210) sont disposés dans la première région et l'élément de commande d'angle de faisceau (230) est disposé dans la seconde région,
dans lequel, faisant face à l'élément support (202), l'élément lentille (240) comporte un évidement de sorte que l'élément fléchissant (210) et l'élément de commande d'angle de faisceau (230) sont introduits dans l'élément lentille (240), de façon à commander l'angle de faisceau de la lumière émise à partir de la puce de dispositif électroluminescent (220), dans lequel l'élément réfléchissant (210) et l'élément de commande d'angle de faisceau (230) sont en polyphtalamide (PPA) ou en téréphtalate de polycyclohexylène (PCT),
dans lequel une forme de section transversale de la seconde région à l'exclusion de la première région comporte une surface droite présentant un angle,
dans lequel une ligne formée en prolongeant la seconde surface réfléchissante (235) en direction de la surface supérieure de l'élément support (202) est formée pour coïncider avec une ligne formée en prolongeant une délimitation entre la première région et la seconde région en direction de la surface supérieure de l'élément support (202), et
dans lequel une forme de section transversale de l'élément de commande d'angle de faisceau (230) est une forme rectangulaire.

2. Boîtier de dispositif électroluminescent selon la revendication 1, dans lequel la seconde surface réfléchissante (235) de l'élément de commande d'angle de faisceau (230) est disposée de façon à se trouver parallèle à un côté le plus proche de la puce de dispositif électroluminescent (220) et est espacée de ce dernier.

3. Boîtier de dispositif électroluminescent selon la revendication 2, dans lequel la puce de dispositif électroluminescent (220) est constituée d'une puce ou d'une pluralité de puces de dispositif électroluminescent (220) qui sont disposées espacées les unes des autres.

4. Dispositif électroluminescent comprenant un boîtier de dispositif électroluminescent à angle de faisceau réglé selon l'une quelconque des revendications 1, 2 et 3, dans lequel un angle de faisceau de la lumière émise est réglé à l'aide du boîtier de dispositif électroluminescent.
